(19) Europäisches Patentamt / European Patent Office / Office européen des brevets

(11) **EP 3 071 982 B1**

(12) **FASCICULE DE BREVET EUROPEEN**

(45) Date de publication et mention
de la délivrance du brevet:
**11.03.2020 Bulletin 2020/11**

(21) Numéro de dépôt: **14821717.7**

(22) Date de dépôt: **19.11.2014**

(51) Int Cl.:
***G01R 31/36*** *(2020.01)*

(86) Numéro de dépôt international:
**PCT/FR2014/052968**

(87) Numéro de publication internationale:
**WO 2015/075382 (28.05.2015 Gazette 2015/21)**

(54) **PROCEDE DE DETECTION D'UN DYSFONCTIONNEMENT D'UN SYSTEME DE CONTROLE DE BATTERIE**

VERFAHREN ZUR ERKENNUNG EINER FEHLFUNKTION EINES
BATTERIESTEUERUNGSSYSTEMS

METHOD FOR DETECTING A MALFUNCTION OF A BATTERY CONTROL SYSTEM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.11.2013 FR 1361474**

(43) Date de publication de la demande:
**28.09.2016 Bulletin 2016/39**

(73) Titulaire: **Commissariat à l'Energie Atomique et
aux Energies
Alternatives
75015 Paris (FR)**

(72) Inventeurs:
• **BACQUET, Sylvain**
 **F-38470 Chasselay (FR)**
• **LOMBARDI, Warody**
 **F-38000 Grenoble (FR)**

(74) Mandataire: **Cabinet Beaumont
4, Place Robert Schuman
B.P. 1529
38025 Grenoble Cedex 1 (FR)**

(56) Documents cités:
| | |
|---|---|
| EP-A1- 1 391 962 | EP-A1- 2 230 529 |
| EP-A2- 2 043 222 | EP-A2- 2 421 113 |
| DE-A1-102011 005 603 | DE-A1-102011 080 512 |
| DE-A1-102011 083 277 | DE-A1-102012 201 528 |
| US-A1- 2005 225 290 | US-A1- 2005 242 776 |
| US-A1- 2009 309 545 | US-A1- 2011 254 502 |
| US-A1- 2011 288 723 | US-A1- 2012 025 769 |

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente demande de brevet revendique la priorité de la demande de brevet français FR13/61474.

Domaine

La présente demande concerne le domaine des systèmes de contrôle de batterie électrique, généralement désignés dans la technique par le sigle BMS, de l'anglais "Battery Management System". Elle vise en particulier un procédé de détection d'un dysfonctionnement d'un système de contrôle de batterie.

Exposé de l'art antérieur

Une batterie électrique est un groupement de plusieurs cellules élémentaires rechargeables (piles, accumulateurs, etc.) reliées en série et/ou en parallèle entre deux noeuds ou bornes de fourniture de tension. Une batterie électrique est généralement couplée à un système de contrôle de la batterie ou BMS, c'est-à-dire un système électronique adapté à mettre en oeuvre diverses fonctions telles que des fonctions de protection de la batterie pendant des phases de charge ou de décharge, notamment en empêchant les cellules de la batterie de fonctionner en dehors de gammes nominales de température, tension, courant, etc., des fonctions d'équilibrage des cellules de la batterie, des fonctions de surveillance de l'état de charge et/ou de l'état de vieillissement de la batterie, etc. Les systèmes de contrôle de batterie peuvent comporter un nombre relativement important de capteurs, agencés pour mesurer des tensions, courants, températures, etc., en divers points de la batterie. Ces capteurs peuvent être reliés à une unité de traitement et de contrôle adaptée à lire les valeurs de sortie des capteurs, à traiter et interpréter ces valeurs, et, en fonction des valeurs lues, à commander, si nécessaire, des mesures de contrôle telle que l'interruption ou la diminution d'un courant de charge ou de décharge de la batterie.

Il existe un besoin pour une solution permettant de détecter un éventuel dysfonctionnement d'un système de contrôle de batterie, et, plus particulièrement, d'un ou plusieurs capteurs d'un système de contrôle de batterie.

En effet, de façon classique, lorsqu'un capteur d'un système de contrôle de batterie fournit une valeur anormale, on présume, par précaution, que la batterie est défaillante, et des opérations ou mesures de mise en sécurité de la batterie sont commandées par le système de contrôle. Les mesures de mise en sécurité sont généralement contraignantes pour l'utilisateur, et peuvent notamment comporter la déconnexion de la batterie. En particulier, dans certains domaines sensibles tels que le domaine des batteries de forte puissance pour véhicule électrique, lorsqu'une valeur anormale est détectée, la batterie est immédiatement déconnectée pour ne prendre aucun risque, ce qui entraine une immobilisation du véhicule. Le pack comportant la batterie et son système de contrôle est ensuite examiné par un technicien spécialisé, dans une procédure relativement longue et coûteuse, afin d'identifier l'origine du défaut.

Toutefois, dans certains cas, lorsqu'un capteur d'un système de contrôle de batterie fournit une valeur anormale, c'est en fait le capteur lui-même qui est défaillant, et non pas la batterie. Il serait souhaitable de pouvoir distinguer une défaillance du système de contrôle de batterie d'une défaillance effective de la batterie, pour pouvoir éviter une procédure contraignante de mise en sécurité de la batterie si une telle procédure n'est pas nécessaire. A titre d'exemple, en cas de défaillance d'un capteur du système de contrôle, on pourrait se contenter d'alerter l'utilisateur du défaut, pour lui permettre de faire réparer à sa convenance le système de contrôle, sans pour autant interrompre le fonctionnement de la batterie.

Pour permettre de différencier une défaillance d'un capteur du système de contrôle de la batterie d'une défaillance effective de la batterie, on a déjà proposé de dupliquer certains capteurs du système de contrôle, c'est-à-dire de prévoir deux capteurs identiques agencés pour mesurer une même grandeur physique, par exemple la tension entre deux noeuds de la batterie, ou la température d'une zone particulière de la batterie. En cas d'incohérence entre les mesures fournies par les deux capteurs, on peut en déduire que l'un des capteurs est défaillant. La prévision de capteurs redondants entraine toutefois une augmentation du coût et de l'encombrement du système de contrôle.

Des documents pertinents de l'état de la technique sont DE 10 2011 005603 A1 et US-2013/0162052.

Il serait souhaitable de pouvoir disposer d'une solution fiable, peu coûteuse, et peu encombrante permettant de détecter un dysfonctionnement d'un système de contrôle de batterie électrique.

Résumé

Un procédé de détection d'un dysfonctionnement d'un capteur de tension d'un système de contrôle d'une batterie selon l'invention est défini dans la revendication indépendante 1.

Selon un mode de réalisation, lorsqu'un dysfonctionnement d'un capteur est détecté, l'unité de traitement détermine la valeur de la grandeur physique que ce capteur était destiné à mesurer, à partir de valeurs de sortie d'autres capteurs du système.

Selon un mode de réalisation, l'étape de détermination de la valeur de la grandeur physique que le capteur défaillant était destiné à mesurer, comprend la résolution, par l'unité de traitement, d'au moins une équation de maille ou de noeud comportant le capteur défaillant.

Selon un mode de réalisation, les capteurs sont destinés à mesurer des températures de zones distinctes de la batterie, et, à l'étape b), on détermine si les valeurs lues sont cohérentes avec les phénomènes de diffusion thermique dans et autour de la batterie.

Selon un mode de réalisation de la présente invention, le procédé comprend : une première étape de lecture des valeurs de sortie des capteurs à un premier instant ; une étape de détermination par calcul, au moyen de l'unité de traitement, en se basant sur les valeurs lues lors de la première étape de lecture, de la température attendue au niveau d'au moins un premier capteur du système après une période de diffusion ; et une deuxième étape de lecture de la valeur de sortie du premier capteur, postérieure à la première étape de lecture d'une durée égale à la période de diffusion.

Selon un mode de réalisation de la présente invention, ce procédé comporte en outre une étape de comparaison, au moyen de l'unité de traitement, de la valeur de sortie lue lors de la deuxième étape de lecture et de la valeur attendue déterminée par calcul.

Selon un mode de réalisation, le procédé comporte en outre une étape de détection d'une éventuelle variation de la valeur de sortie du premier capteur.

Selon un mode de réalisation, la période de diffusion est comprise entre 10 secondes et 5 minutes.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

  la figure 1 représente de façon schématique un exemple d'un assemblage comportant une batterie et un système de contrôle de la batterie ; et
  la figure 2 représente de façon schématique un autre exemple d'un assemblage comportant une batterie et un système de contrôle de la batterie.

Description détaillée

Selon un aspect des modes de réalisation décrits, on prévoit un procédé de détection d'un dysfonctionnement d'un système de contrôle de batterie comportant une pluralité de capteurs destinés à mesurer des grandeurs physiques distinctes de la batterie. Ce procédé comprend la lecture des valeurs de sortie des capteurs. Il comprend en outre une étape de vérification, au moyen d'un dispositif ou d'une unité de traitement, que les valeurs lues sont cohérentes avec un phénomène physique conditionnant des relations entre au moins deux des grandeurs distinctes mesurées.

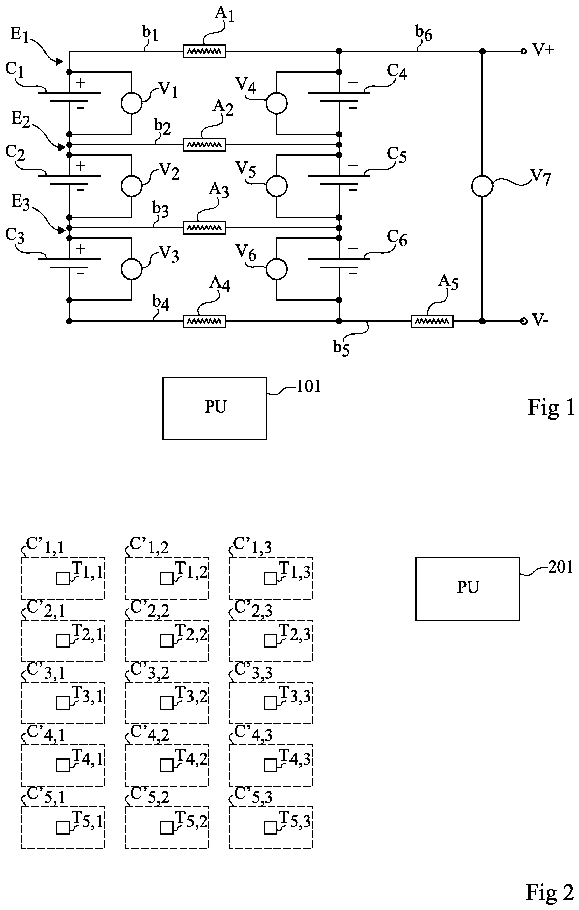

Selon un premier mode de réalisation, qui sera décrit plus en détail en relation avec la figure 1, les capteurs sont des capteurs de courant et/ou tension, et le phénomène physique sur lequel on se base pour vérifier la cohérence des valeurs fournies par les capteurs est le principe de la conservation de l'énergie dans un système électrique, exprimé par les lois de Kirchhoff.

Selon un deuxième mode de réalisation qui sera décrit plus en détail en relation avec la figure 2, les capteurs sont des capteurs de température, et le phénomène physique sur lequel on se base pour vérifier la cohérence des valeurs fournies par les capteurs est la diffusion thermique, qui peut s'exprimer analytiquement par des équations de diffusion.

Ces deux modes de réalisation sont combinables dans le cas d'un système de contrôle de batterie comportant à la fois des capteurs de tension et/ou courant et des capteurs de température.

La figure 1 représente schématiquement un exemple d'un assemblage comportant une batterie de six cellules élémentaires $C_i$, avec i entier allant de 1 à 6, et un système de contrôle de cette batterie. Dans cet exemple, les cellules $C_i$ sont regroupées en trois étages $E_1$, $E_2$ et $E_3$ comportant chacun deux cellules en parallèle, les étages $E_1$, $E_2$ et $E_3$ étant reliés en série entre deux bornes V+ et V-, respectivement positive et négative, de fourniture de tension de la batterie. L'homme de l'art saura adapter les modes de réalisation décrits à des batteries comportant un nombre de cellules différent de six, un nombre d'étages différent de trois, et/ou un nombre de cellules par étage différent de deux.

Dans l'exemple représenté, l'étage $E_1$ comprend les cellules $C_1$ et $C_4$, l'étage $E_2$ comprend les cellules $C_2$ et $C_5$, et l'étage $E_3$ comprend les cellules $C_3$ et $C_6$. Dans cet exemple, un conducteur $b_1$, par exemple une piste conductrice ou un fil conducteur, relie la borne positive de la cellule $C_1$ à la borne positive de la cellule $C_4$, un conducteur $b_2$ relie le point milieu entre la borne négative de la cellule $C_1$ et la borne positive de la cellule $C_2$ au point milieu entre la borne négative de la cellule $C_4$ et la borne positive de la cellule $C_5$, un conducteur $b_3$ relie le point milieu entre la borne négative de la cellule $C_2$ et la borne positive de la cellule $C_3$ au point milieu entre la borne négative de la cellule $C_5$ et la borne positive de la cellule $C_6$, un conducteur $b_4$ relie la borne négative de la cellule $C_3$ à la borne négative de la cellule $C_6$.

De plus, dans cet exemple, un conducteur $b_5$ relie le conducteur $b_4$ à la borne négative V- de la batterie, et un conducteur $b_6$ relie le conducteur $b_1$ à la borne positive V+ de la batterie.

Dans cet exemple, le système de contrôle de la batterie comporte six capteurs de tension $V_1$ à $V_6$, respectivement agencés pour mesurer la tension aux bornes des cellules $C_1$ à $C_6$, un septième capteur de tension $V_7$, agencé pour mesurer la tension entre les bornes V+ et V- de la batterie, et cinq capteurs de courant $A_1$ à $A_5$, respectivement agencés pour mesurer le courant circulant dans les conducteurs $b_1$ à $b_5$. Le système de contrôle de batterie de la figure 1 comprend en outre une unité de traitement et de contrôle 101 (PU) adaptée à lire les valeurs de sortie des capteurs, et, en fonction des valeurs lues, à commander diverses mesures ou opérations de contrôle de la batterie.

Pour détecter un dysfonctionnement du système de contrôle de batterie de la figure 1, on prévoit, dans cet exemple, de lire les valeurs de sortie des capteurs $V_1$ à $V_7$ et $A_1$ à $A_5$, puis de vérifier, au moyen de l'unité de traitement 101, que les valeurs de sortie lues sont cohérentes avec les lois de Kirchhoff de conservation de l'énergie dans un système électrique, et plus particulièrement avec la loi des mailles et/ou la loi des noeuds. Plus particulièrement, on prévoit de vérifier, au moyen de l'unité de traitement 101, qu'une ou plusieurs équations découlant de la loi des mailles et/ou de la loi des noeuds pour le système considéré, sont satisfaites par les valeurs de sortie des capteurs.

Dans l'exemple de la figure 1, chacun des capteurs de courant $A_1$ à $A_5$ comprend un élément faiblement résistif, par exemple de résistance inférieure à 5 milliohms, inséré sur le chemin de passage du courant que l'on souhaite mesurer, et un dispositif de mesure de la tension aux bornes de l'élément faiblement résistif. Les valeurs de sortie des capteurs $A_1$ à $A_5$ sont donc en fait des valeurs de tension représentatives des courants circulant dans les conducteurs $b_1$ à $b_5$. Dans cet exemple, la détection de dysfonctionnement du système de contrôle de la batterie peut donc être basée uniquement sur le respect, par les valeurs de sortie des capteurs $V_1$ à $V_7$ et $A_1$ à $A_5$, d'une ou plusieurs équations découlant de la loi des mailles pour le système considéré. Les modes de réalisation décrits ne se limitent toutefois pas à ce cas particulier.

A titre d'exemple, si on considère, dans l'assemblage de la figure 1, la maille formée par la cellule $C_2$, le conducteur $b_2$, la cellule $C_5$ et le conducteur $b_3$, et si l'on désigne les valeurs de sortie en tension des capteurs $V_1$ à $V_7$ et $A_1$ à $A_5$ par les mêmes références que les capteurs eux-mêmes, l'équation $V_2-A_2-V_5+A_3 = 0$ découle de la loi des mailles pour cette portion du système de contrôle, et devrait être satisfaite par les valeurs de sortie des capteurs. Si cette équation n'est pas respectée par les valeurs de sortie des capteurs, on peut en déduire qu'au moins un des capteurs $V_2$, $A_2$, $V_5$ et $A_3$ est défaillant. On notera qu'au sens de la présente demande, on considère qu'une équation de maille est satisfaite si la valeur absolue de la somme des valeurs de sortie des capteurs de la maille est inférieure ou égale à un seuil, qui peut être légèrement supérieur à zéro pour tenir compte des imprécisions de mesure des capteurs.

Selon un aspect du premier mode de réalisation, pour un système donné de contrôle de batterie, on peut identifier un ensemble d'une ou plusieurs mailles tel que chacun des capteurs que l'on souhaite tester soit compris dans au moins une maille de l'ensemble. Pour détecter un éventuel dysfonctionnement du système de contrôle, on peut alors prévoir de lire les valeurs de sortie des capteurs, puis de vérifier, au moyen de l'unité de traitement 101, que les valeurs lues satisfont aux différentes équations de maille identifiées. Si au moins une équation de maille n'est pas respectée par les valeurs de sortie des capteurs, on peut en déduire qu'au moins un capteur du système est défaillant.

A titre d'exemple, pour détecter un éventuel dysfonctionnement du système de contrôle de batterie de la figure 1, on peut prévoir de vérifier que les valeurs de sortie des capteurs satisfont aux équations de maille $V_3+V_2+V_1-A_1-V_4-V_5-V_6+A_4 = 0$ et $V_2-A_2+V_4-V_7+A_5+V_5+A_3 = 0$. Si l'une de ces deux équations de maille n'est pas vérifiée, on peut en déduire qu'au moins un capteur du système de contrôle de la figure 1 est défaillant. L'homme de l'art saura identifier d'autres ensembles de mailles comportant la totalité des capteurs à tester, et utiliser les équations de maille correspondantes pour détecter une éventuelle défaillance du système de contrôle de la batterie.

Dans certaines applications, on peut en outre souhaiter localiser le ou les capteurs défaillants du système de contrôle de la batterie, par exemple afin de faciliter leur remplacement, ou pour pouvoir reconfigurer le système de contrôle dans un mode de fonctionnement dégradé n'utilisant pas les valeurs de sortie de ces capteurs défaillants.

Pour cela, on peut prévoir, pour chaque capteur du système, d'identifier l'ensemble de toutes les mailles du système qui comportent le capteur. Pour détecter et localiser un éventuel dysfonctionnement du système de contrôle, on peut alors prévoir de lire les valeurs de sortie des capteurs, puis de vérifier, au moyen de l'unité de traitement 101, que les valeurs lues satisfont aux différentes équations de maille identifiées. Si au moins une équation de maille n'est pas respectée par les valeurs de sortie des capteurs, on peut en déduire qu'au moins un capteur du système est défaillant. Si, pour un capteur donné, aucune des équations des mailles qui comportent le capteur n'est satisfaite, on peut en déduire que le capteur est défaillant ou très probablement défaillant.

A titre d'exemple, dans l'assemblage de la figure 1, si l'on considère le capteur $A_3$, l'ensemble des équations de maille de l'assemblage comportant le capteur $A_3$ est le suivant :

$$V_2-A_2-V_5+A_3 = 0,$$

$$V_3 + A_4 - V_6 - A_3 = 0,$$

$$V_2 + V_1 - A_1 - V_4 - V_5 + A_3 = 0,$$

$$V_2 + V_1 - A_1 - V_7 + A_5 + V_6 + A_3 = 0,$$

$$V_2 - A_2 + V_4 - V_7 + A_5 + V_6 + A_3 = 0,$$

$$V_5 + A_2 + V_1 - A_1 - V_7 + A_5 + A_4 + V_3 - A_3 = 0,$$

et

$$V_5 + V_4 - V_7 + A_5 + A_4 - V_3 - A_3 = 0.$$

Si aucune des équations de cet ensemble n'est vérifiée par les valeurs de sortie des capteurs, on peut en déduire que le capteur $A_3$ est défaillant ou très probablement défaillant.

On notera que lorsqu'un capteur défaillant est identifié, on peut déterminer par calcul la mesure manquante à partir des valeurs de sortie d'autres capteurs du système, en utilisant une ou plusieurs des équations de Kirchhoff susmentionnées. Pour cela, on peut par exemple considérer une maille comportant le capteur défaillant et dont tous les autres capteurs sont présumés sains. On prévoit alors, au moyen de l'unité de traitement 101, de résoudre l'équation de cette maille, dont la seule inconnue est la tension aux bornes du capteur défaillant. De cette façon, l'unité de traitement peut continuer à surveiller l'évolution de la grandeur physique que le capteur défaillant était destiné à mesurer.

A titre d'exemple, le procédé décrit ci-dessus de détection de dysfonctionnement selon le premier mode de réalisation, peut être mis en oeuvre périodiquement par l'unité de contrôle et de traitement 101, par exemple à une périodicité comprise entre 10 secondes et deux minutes.

Un avantage de ce procédé est qu'il permet, de façon simple et peu coûteuse, de détecter une défaillance du système de contrôle de la batterie, et notamment de distinguer une telle défaillance d'une défaillance de la batterie elle-même. On peut ainsi éviter de contraignantes opérations de mise en sécurité de la batterie, lorsque celles-ci ne sont pas indispensables.

Diverses variantes et modifications du premier mode de réalisation apparaîtront à l'homme de l'art.

En particulier, l'homme de l'art saura adapter le procédé décrit ci-dessus à d'autres architectures de système de contrôle de batterie que celle de l'exemple de la figure 1.

De plus, l'homme de l'art saura mettre en oeuvre un procédé du type décrit ci-dessus en utilisant, pour vérifier la cohérence des valeurs de sortie des capteurs du système, non seulement des équations de maille, mais aussi des équations de noeud du système (somme des courants entrants sur un noeud égale à la somme des courants sortants de ce noeud), ou uniquement des équations de noeud.

Par ailleurs, dans le cas d'un système de contrôle comportant un nombre élevé de capteurs de tension et/ou courant, on peut prévoir de ne pas vérifier systématiquement la totalité des équations de maille et/ou de noeuds du système, mais seulement une partie de ces équations, y compris pour localiser les capteurs défaillants. A titre d'exemple, on peut prévoir, pour chaque capteur du système, d'identifier un ensemble de N mailles du système comportant le capteur, où N est un nombre entier inférieur au nombre total de mailles du système comportant le capteur. Pour détecter et localiser un dysfonctionnement du système de contrôle, on peut alors prévoir de lire les valeurs de sortie des capteurs, puis de vérifier, au moyen de l'unité de traitement 101, que les valeurs lues satisfont aux différentes équations de maille identifiées. Si, pour un capteur donné, aucune des N équations de maille identifiées comportant le capteur n'est satisfaite, on peut en déduire que le capteur a une forte probabilité d'être défaillant. Ceci permet de réduire la complexité de calcul du procédé de localisation de défaillances, tout en garantissant des performances en localisation de défauts statistiquement fiables.

La figure 2 représente schématiquement un exemple d'un assemblage comportant une batterie de quinze cellules élémentaires, et un système de contrôle de cette batterie.

Dans cet exemple, les cellules de la batterie sont disposées selon une matrice de cinq lignes et trois colonnes. Sur la figure 2, les cellules sont représentées par des rectangles en traits pointillés, et sont désignées par les références $C'_{j,k}$, où j est un entier allant de 1 à 5 désignant le rang de la ligne de la matrice à laquelle appartient la cellule, et k est un entier allant de 1 à 3 désignant le rang de la colonne de la matrice à laquelle appartient la cellule. Le schéma d'interconnexion des cellules C'$_{j,k}$ de la batterie n'a pas été représenté sur la figure 2, le deuxième mode de réalisation étant compatible avec tout schéma d'interconnexion de cellules élémentaires dans une batterie. On notera en outre que le deuxième mode de réalisation est compatible avec des batteries présentant un nombre de cellules différent de quinze, et/ou un agencement des cellules différent de celui de la figure 2.

Dans cet exemple, le système de contrôle de la batterie comporte quinze capteurs de température T$_{j,k}$, respectivement agencés pour mesurer la température au voisinage des cellules C'$_{j,k}$. Ainsi, les capteurs T$_{j,k}$ sont agencés pour mesurer la température de quinze points distincts de la batterie. Le système de contrôle de batterie de la figure 2 comprend en outre une unité de traitement et de contrôle 201 (PU) adaptée à lire les valeurs de sortie des capteurs T$_{j,k}$, et, en fonction des valeurs lues, à commander diverses mesures ou opérations de contrôle de la batterie.

Pour détecter un dysfonctionnement du système de contrôle de batterie de la figure 2, on prévoit, dans cet exemple, de lire les valeurs de sortie des capteurs T$_{j,k}$, et, en cas de variation (augmentation ou diminution) significative de la valeur de sortie de l'un des capteurs, que l'on appellera capteur primaire, de vérifier qu'après une certaine période choisie en fonction de la vitesse de diffusion de la chaleur dans la batterie, par exemple une période de l'ordre de 10 secondes à 5 minutes, un ou plusieurs autres capteurs T$_{j,k}$, que l'on appellera capteurs secondaires, de préférence voisins du capteur primaire, mesurent eux aussi une variation de température cohérente avec la variation de température du capteur primaire. Si l'un des capteurs secondaires ne mesure pas de variation de température cohérente avec la variation de température du capteur primaire, on peut en déduire que l'un des capteurs primaires ou secondaires est probablement défaillant. Si aucun des capteurs secondaires ne mesure de variation de température cohérente avec la variation de température du capteur primaire, on peut en déduire que le capteur primaire est probablement défaillant. Si seule une minorité de capteurs secondaires, par exemple un seul capteur secondaire, ne mesure pas de variation de température représentative de la variation de température du capteur primaire, on peut en déduire que ces capteurs secondaires minoritaires sont probablement défaillants.

A titre d'exemple, pour détecter une défaillance du système de contrôle de batterie de la figure 2, le fonctionnement suivant peut être mis en oeuvre.

Dans un premier temps, on lit régulièrement les valeurs de sortie des capteurs T$_{j,k}$, par exemple à la cadence requise par le système de contrôle de batterie pour effectuer des opérations usuelles de contrôle de la batterie.

Lors de ces lectures successives, on prévoit de détecter, au moyen de l'unité de traitement 201, un éventuel évènement thermique remarquable tel qu'une variation non négligeable (augmentation ou diminution) de la valeur de sortie de l'un des capteurs.

Lorsqu'un tel évènement thermique se produit, le procédé de détection de dysfonctionnement suivant peut être mis en oeuvre par l'unité de traitement 201.

Lors d'une première phase, l'unité de traitement 201 détermine par calcul la variation attendue, à l'issue d'une période de diffusion, de la température au niveau de capteurs voisins (ou capteurs secondaires) du capteur ayant mesuré l'événement thermique remarquable (ou capteur primaire). Pour cela, l'unité de traitement 201 se base par exemple sur des conditions initiales correspondant aux valeurs de sortie de l'ensemble des capteurs du système à l'instant de l'événement remarquable, et simule par calcul l'évolution des températures dans le système à partir de ces conditions initiales, en utilisant des équations de diffusion thermique. A titre d'exemple non limitatif, pour simplifier les calculs effectués par l'unité de traitement 201, on peut considérer des conditions de bord constantes, c'est-à-dire considérer que la température aux bords de l'assemblage ne varie pas.

A la fin de la période de diffusion considérée pour la simulation, les valeurs de sortie des capteurs sont à nouveau lues.

L'unité de traitement 201 compare alors, pour chacun des capteurs secondaires, la valeur de température simulée déterminée par calcul par l'unité de traitement, à la valeur réelle de sortie du capteur à la fin de la période de diffusion considérée pour la simulation.

Si l'écart entre la valeur simulée et la valeur réelle dépasse un seuil, on peut considérer qu'il existe une incohérence entre les valeurs de sortie des capteurs T$_{j,k}$ et les phénomènes de diffusion thermique qui régissent les relations entre les températures mesurées par ces capteurs. On peut en déduire un dysfonctionnement du système de contrôle de la batterie. En tenant compte du nombre d'incohérences détecté et des capteurs concernés par ces incohérences, l'unité de traitement 201 peut éventuellement localiser le ou les capteurs défaillants. Lorsqu'un capteur défaillant est localisé, il est en outre possible, par la résolution d'équations de diffusion, d'estimer la température réelle au voisinage du capteur défaillant, à partir des valeurs de sorties fournies par des capteurs voisins valides.

L'équation qui régit le phénomène de diffusion thermique reliant entre elles les grandeurs mesurées par les capteurs T$_{j,k}$ de température est l'équation de diffusion de la température dans l'espace et dans le temps, qui peut par exemple s'exprimer en approximation sous la forme de différences finies par la formule suivante :

$$\frac{T(x, y, t + 1) - T(x, y, t)}{\Delta t} = r_x \left( \frac{T(x + 1, y, t) - 2T(x, y, t) + T(x - 1, y, t)}{\Delta x^2} \right)$$

$$+ r_y \left( \frac{T(x, y + 1, t) - 2T(x, y, t) + T(x, y - 1, t)}{\Delta y^2} \right) + (1 - 2r_x - 2r_y)T(x, y, t)$$

où x et y désignent les cordonnées de points d'un domaine spatial discrétisé à deux dimensions, t désigne un instant d'un domaine temporel discrétisé, $\Delta x$, $\Delta y$ et $\Delta t$ désignent respectivement les pas de discrétisation en x, y et t des domaines spatial et temporel considérés, et T(x,y,t) désigne la température, à l'instant t, du point de coordonnées (x, y) dans les domaines spatial et temporel considérés, et où les grandeurs $r_x$ et $r_y$ s'expriment comme suit :

$$r_x = \alpha \frac{\Delta t}{\Delta x^2} \; ; \; \text{et} \; r_y = \alpha \frac{\Delta t}{\Delta y^2},$$

où $\alpha$ désigne un terme relatif aux constantes physiques thermiques du système.

Dans le cas où les cellules sont séparées les unes des autres par de l'air, on peut exprimer le terme $\alpha$ par la formule $\alpha = (K \cdot C_p)/r_0$, où K désigne la conductivité thermique de l'air, $r_0$ désigne le volume massique de l'air, et $C_p$ la constante thermique de l'air. A titre d'exemple, avec K = 0,025 W.m$^{-1}$.K$^{-1}$, $r_0$ = 1,2 kg.m$^{-3}$, et $C_p$ = 1000 J.kg$^{-1}$.K$^{-1}$, on obtient une valeur $\alpha$ de l'ordre de 2.083*10$^{-5}$.

Pour une batterie occupant un espace approximativement rectangulaire de 22 cm dans la direction x et de 11 cm dans la direction y, si le nombre de points de discrétisation de l'espace occupé par la batterie est de 100 dans la coordonnée x et de 50 dans la coordonnée y, et si le pas de discrétisation temporel $\Delta t$ est de 0,01 s, on obtient les valeurs $r_x$ = 0,0422 et $r_y$ = 0,0413.

A partir de l'équation discrétisée de diffusion thermique susmentionnée, l'unité de traitement 201 peut déterminer, par simulation en éléments finis, la variation attendue, à l'issue d'une période de diffusion, de la température au niveau de capteurs dits secondaires, suite à un évènement thermique remarquable au niveau d'un capteur dit primaire. Cette même équation peut, le cas échéant, être utilisée par l'unité de traitement 201 en cas de défaillance d'un capteur, pour estimer la température au niveau de ce capteur à partir de valeurs de sortie de capteurs voisins.

Les modes de réalisation décrits ne se limitent toutefois pas à l'utilisation de cette équation de diffusion particulière pour vérifier la cohérence des valeurs de sortie des capteurs avec les lois physiques de diffusion thermique dans la batterie, ou pour estimer une valeur manquante de température au niveau d'un éventuel capteur défaillant.

Un avantage du deuxième mode de réalisation est qu'il permet, de façon simple et peu coûteuse, de détecter une défaillance du système de contrôle de la batterie, et notamment de différencier une défaillance d'un capteur de température du système de contrôle d'une défaillance de la batterie elle-même. On peut ainsi éviter de contraignantes opérations de mise en sécurité de la batterie, lorsque celles-ci ne sont pas indispensables.

Diverses variantes et modifications du deuxième mode de réalisation apparaîtront à l'homme de l'art.

En particulier, l'homme de l'art saura adapter le procédé décrit ci-dessus à d'autres architectures de système de contrôle de batterie que celle de l'exemple de la figure 1, par exemple des systèmes comportant moins d'un capteur de température par cellule, ou plus d'un capteur de température par cellule.

**Revendications**

1. Procédé de détection d'un dysfonctionnement d'un capteur de tension d'un système de contrôle d'une batterie comportant plusieurs étages (E$_i$) reliés en série, chaque étage comportant plusieurs cellules (C$_i$) reliées en parallèle par des conducteurs (b$_i$), le système de contrôle comportant une pluralité de capteurs de tension (V$_i$, A$_i$), ladite pluralité de capteurs de tension comprenant un capteur de tension aux bornes de chaque cellule (C$_i$) et conducteur (b$_i$), de la batterie, les capteurs (V$_i$, A$_i$) définissant un ensemble de mailles tel que chaque capteur soit compris dans plusieurs mailles de l'ensemble, et tel que dans chacune des mailles, en fonctionnement normal, la somme des valeurs de sortie des capteurs de tension de la maille soit égale à 0 aux imprécisions de mesure des capteurs près, ce procédé comprenant les étapes suivantes :

   a) lire des valeurs de sortie desdits capteurs ; et
   b) déterminer, au moyen d'une unité de traitement (101), si les valeurs lues satisfont aux équations de maille dudit ensemble de mailles, une équation de maille étant considérée comme satisfaite si la somme des valeurs de sortie des capteurs de la maille est égale à 0 aux imprécisions de mesure des capteurs près.

**2.** Procédé selon la revendication 1, dans lequel, lorsqu'un dysfonctionnement d'un capteur ($V_i$, $A_i$) est détecté, l'unité de traitement (101) détermine la valeur de la tension que ce capteur était destiné à mesurer, à partir de valeurs de sortie d'autres capteurs du système.

**3.** Procédé selon la revendication 2, dans lequel, l'étape de détermination de la valeur de la tension que le capteur défaillant était destiné à mesurer, comprend la résolution, par l'unité de traitement (101), d'au moins une équation de maille comportant le capteur défaillant.

**4.** Procédé selon l'une quelconque des revendications 1 à 3, dans lequel le système de contrôle de batterie comprend en outre une pluralité de capteurs de température ($T_{j,k}$) destinés à mesurer des températures de zones distinctes de la batterie, ce procédé comprenant en outre les étapes suivantes :

   c) lire des valeurs de sortie desdits capteurs de température ; et
   d) déterminer, au moyen de l'unité de traitement (101), si les valeurs lues sont cohérentes avec les phénomènes de diffusion thermique dans et autour de la batterie.

**5.** Procédé selon la revendication 4, comprenant :

   une première étape de lecture des valeurs de sortie des capteurs de température ($T_{j,k}$) à un premier instant ;
   une étape de détermination par calcul, au moyen de l'unité de traitement (101), en se basant sur les valeurs lues lors de la première étape de lecture, de la température attendue au niveau d'au moins un premier capteur de température ($T_{j,k}$) du système après une période de diffusion ; et
   une deuxième étape de lecture de la valeur de sortie dudit au moins un premier capteur de température ($T_{j,k}$), postérieure à la première étape de lecture d'une durée égale à ladite période de diffusion.

**6.** Procédé selon la revendication 5, comportant en outre une étape de comparaison, au moyen de l'unité de traitement (201), de la valeur de sortie lue lors de la deuxième étape de lecture et de la valeur attendue déterminée par calcul.

**7.** Procédé selon la revendication 5 ou 6, comportant en outre une étape de détection d'une éventuelle variation de la valeur de sortie dudit au moins un premier capteur de température ($T_{j,k}$).

**8.** Procédé selon l'une quelconque des revendications 5 à 7, dans lequel ladite période de diffusion est comprise entre 10 secondes et 5 minutes.

**Patentansprüche**

**1.** Ein Verfahren zum Erfassen einer Fehlfunktion eines Batteriemanagementsystems mit einer Vielzahl von Stufen ($E_i$), die in Reihe geschaltet sind, wobei jede Stufe eine Vielzahl von Zellen ($C_i$) aufweist, die mittels Konduktoren ($b_i$) parallel geschaltet sind, wobei das Managementsystem eine Vielzahl von Spannungssensoren ($V_i$, $A_i$) aufweist, wobei die Vielzahl von Spannungssensoren jeweils einen Spannungssensor entlang jeder Zelle ($C_i$) und jedes Konduktors ($b_i$) der Batterie aufweist, wobei die Sensoren ($V_i$, $A_i$) einen Satz von Netzen definieren, so dass jeder Sensor in mehrere Netze des Satzes einbezogen ist, und so, dass in jedem einzelnen der Netze, bei Normalbetrieb, die Summe von Ausgabewerten der Spannungssensoren des Netzes gleich Null im Rahmen der Sensormessabweichungen ist, wobei das Verfahren die folgenden Schritte aufweist:

   a) Auslesen der Ausgabewerte der Sensoren; und
   b) Bestimmen, mittels einer Verarbeitungseinheit (101), ob die Netzgleichungen des Satzes von Netzen von den ausgelesenen Werten erfüllt werden, wobei eine Netzgleichung als erfüllt gilt, wenn die Summe von Ausgabewerten der Sensoren des Netzes gleich Null im Rahmen der Sensormessabweichungen ist.

**2.** Das Verfahren nach Anspruch 1, wobei, sobald eine Fehlfunktion eines Sensors ($V_i$, $A_i$) detektiert wird, die Verarbeitungseinheit (101) den Wert der physikalischen Größe ermittelt, die dieser Sensor messen sollte, und zwar basierend auf den Ausgabewerten anderer Sensoren des Systems.

**3.** Das Verfahren nach Anspruch 2, wobei der Schritt des Bestimmens des Werts der physikalischen Größe, die der fehlerhafte Sensor messen sollte, die Auflösung mindestens einer Netz- oder Knotengleichung inklusive des fehlerhaften Sensors durch die Verarbeitungseinheit (101) aufweist.

4. Das Verfahren nach Anspruch 1, wobei das Batteriemanagementsystem weiterhin eine Vielzahl von Temperatursensoren ($T_{j,\,k}$) bestimmt zum Messen von Temperaturen bestimmter Batteriezonen, wobei das Verfahren weiterhin die folgenden Schritte aufweist:

c) Auslesen der Ausgabewerte der Temperatursensoren; und
d) Bestimmen, mittels der Verarbeitungseinheit (101), ob die ausgelesenen Werte konsistent mit den Phänomenen thermischer Diffusion innerhalb der und um die Batterie herum sind.

5. Das Verfahren nach Anspruch 4, das Folgendes aufweist:

einen ersten Schritt des Auslesens der Ausgabewerte der Sensoren ($T_{j,\,k}$) zu einem ersten Zeitpunkt;
einen Bestimmungsschritt mittels Berechnen, mittels der Verarbeitungseinheit (201), und zwar basierend auf den während des ersten Leseschritts ausgelesenen Werten, der erwarteten Temperatur auf Höhe des mindestens einen ersten Sensors ($T_{j,\,k}$) des Systems nach einer Diffusionszeit; und
einen zweiten Schritt des Auslesens des Ausgabewerts des mindestens einen ersten Sensors ($T_{j,\,k}$), und zwar im Anschluss an den ersten Ausleseschritt mittels einer Zeitspanne, die gleich der Diffusionszeit ist.

6. Das Verfahren nach Anspruch 5, das weiterhin Folgendes aufweist:
einen Schritt des Vergleichens, mittels der Verarbeitungseinheit (201), des während des zweiten Leseschrittes ausgelesenen Ausgabewerts und des durch Berechnung bestimmten erwarteten Werts.

7. Das Verfahren nach Anspruch 5 oder 6, das weiterhin Folgendes aufweist:
einen Detektionsschritt einer möglichen Variation des Ausgabewerts des mindestens einen ersten Sensors ($T_{j,\,k}$).

8. Das Verfahren nach einem der Ansprüche 5 bis 7, wobei die Diffusionszeit im Rahmen von 10 Sekunden bis 5 Minuten liegt.

## Claims

1. A method of detecting a malfunction of a management system of a battery comprising a plurality of stages ($E_i$) coupled in series, each stage comprising a plurality of cells ($C_i$) coupled in parallel by conductors ($b_i$), the management system comprising a plurality of voltage sensors ($V_i$, $A_i$), said plurality of voltage sensors comprising a voltage sensor across each cell ($C_i$) and conductor ($b_i$), of the battery, the sensors ($V_i$, $A_i$) define a set of meshes such that each sensor is comprised in several meshes of the set, and such that in each one of the meshes, in normal operation, the sum of the output values of the voltage sensors of the mesh is equal to 0 within the sensors measurement inaccuracies, the method comprising the steps of:

a) reading the output values of said sensors; and
b) determining, by means of a processing unit (101), whether the mesh equations of the set of meshes are satisfied by the read values, a mesh equation being considered as satisfied if the sum of the output values of the sensors of the mesh is equal to 0 within the sensors measurement inaccuracies.

2. The method of claim 1, wherein, when a malfunction of a sensor ($V_i$, $A_i$) is detected, the processing unit (101) determines the value of the physical quantity that this sensor was intended to measure, based on output values of other sensors of the system.

3. The method of claim 2, wherein the step of determining the value of the physical quantity that the defective sensor was intended to measure comprises the solving, by the processing unit (101), of at least one mesh or node equation including the defective sensor.

4. The method of claim 1, wherein the battery management system further comprises a plurality of temperature sensors ($T_{j,k}$) intended to measure temperatures of different battery areas, the method further comprising the steps of:

c) reading the output values of said temperature sensors; and

d) determining, by means of the processing unit (101), whether the read values are consistent with the thermal diffusion phenomena inside of and around the battery.

5. The method of claim 4, comprising:

a first step of reading the output values of the sensors ($T_{j,k}$) at a first time;
a step of determining by calculation, by means of the processing unit (101), based on the values read during the first reading step, the temperature expected at the level of at least one first sensor ($T_{j,k}$) of the system after a diffusion period; and
a second step of reading the output value of said at least one first sensor ($T_{j,k}$), posterior to the first reading step by a time period equal to said diffusion period.

6. The method of claim 5, further comprising a step of comparing, by means of the processing unit (201), the output value read during the second reading step and the expected value determined by calculation.

7. The method of claim 5 or 6, further comprising a step of detecting a possible variation of the output value of said at least one first sensor ($T_{j,k}$).

8. The method of any of claims 5 to 7, wherein said diffusion period is in the range from 10 seconds to 5 minutes.

Fig 1

Fig 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1361474
- DE 102011005603 A1
- US 20130162052 A